# EUROPÄISCHE PATENTSCHRIFT

(11) **EP 1 739 758 B1**
(45) Veröffentlichungstag und Bekanntmachung des Hinweises auf die Patenterteilung: **26.08.2015**
(21) Anmeldenummer: 06011526.8
(22) Anmeldetag: 02.06.2006
(51) Int. Cl.: H01L 33/02, H01L 33/30, H01L 33/32, H01S 5/30

(54) **Strahlungsemittierender optoelektronischer Halbleiterchip mit einer Diffusionsbarriere**
Light emitting semiconductor chip with diffision barrier
Dispositif à semi-conducteur électroluminescent avec barrière contre la diffusion

(30) Priorität: 05.08.2005 DE 102005037022; 28.06.2005 DE 102005030152
(43) Veröffentlichungstag der Anmeldung: 03.01.2007
(73) Patentinhaber: OSRAM Opto Semiconductors GmbH, 93055 Regensburg (DE)
(72) Erfinder: Linder, Norbert, 93138 Lappersdorf (DE)
(74) Vertreter: Epping - Hermann - Fischer

(56) Entgegenhaltungen:
- JP-A- 2003 243 698
- JP-A- 2004 356 600
- US-A- 5 345 463
- US-A- 5 442 204
- US-A1- 2002 090 167
- US-A1- 2005 056 824
- HIRAYAMA HIDEKI: "Quaternary InAlGaN-based high-efficiency ultraviolet light-emitting diodes" JOURNAL OF APPLIED PHYSICS, AMERICAN INSTITUTE OF PHYSICS. NEW YORK, US, Bd. 97, Nr. 9, 26. April 2005 (2005-04-26), Seiten 91101-1-091101-19, XP012071158 ISSN: 0021-8979
- GRILLOT P N ET AL: "Acceptor diffusion and segregation in (AlxGa1-x)0.5In0.5P heterostructures" JOURNAL OF APPLIED PHYSICS, AMERICAN INSTITUTE OF PHYSICS. NEW YORK, US, Bd. 91, Nr. 8, 15. April 2002 (2002-04-15), Seiten 4891-4899, XP012056199 ISSN: 0021-8979
- PURSIAINEN OTTO ET AL: "Identification of aging mechanisms in the optical and electrical characteristics of light-emitting diodes" APPLIED PHYSICS LETTERS, AIP, AMERICAN INSTITUTE OF PHYSICS, MELVILLE, NY, Bd. 79, Nr. 18, 29. Oktober 2001 (2001-10-29), Seiten 2895-2897, XP012029253 ISSN: 0003-6951

## Beschreibung

Die Erfindung betrifft einen strahlungsemittierenden optoelektronischen Halbleiterchip nach dem Oberbegriff des Patentanspruchs 1.

Beim Wachstum von p-dotierten Halbleiterschichten tritt oftmals eine unerwünschte Diffusion des Dotierstoffs, beispielsweise Mg oder Zn, in tiefer liegende Halbleiterschichten auf. Eine derartige Diffusion des Dotierstoffs wurde zum Beispiel bei InAlGaP-Schichten, die epitaktisch, insbesondere mittels MOVPE, hergestellt wurden, beobachtet.

Insbesondere bei optoelektronischen Bauelementen, beispielsweise LEDs oder Halbleiterlasern, ist eine Diffusion des p-Dotierstoffs in dem Halbleiterchip nachteilig, da zum Beispiel bekannt ist, dass die Anwesenheit von Mg oder Zn in der aktiven Schicht optoelektronischer Bauelemente zu nichtstrahlenden Prozessen führen kann, welche die Effizienz der Lichterzeugung vermindern. Weiterhin kann durch eine erhöhte Konzentration eines dieser Dotierstoffe in der aktiven Schicht eines optoelektronischen Bauelements eine beschleunigte Alterung des strahlungsemittierenden Bauelements bewirkt werden.

Um eine Diffusion des p-Dotierstoffs aus der p-dotierten Schicht in die aktive Schicht zu vermindern, werden in der Regel eine oder mehrere undotierte Schichten zwischen der aktiven Schicht und der p-dotierten Schicht eingefügt. Derartige undotierte Schichten wirken sich allerdings mit zunehmender Dicke nachteilig auf die optischen und elektronischen Eigenschaften des Halbleiterchips aus. Weiterhin ist aus den Druckschriften DE 10306311 A1 und JP 10209573 A bekannt, eine verspannte Übergitterstruktur zwischen einer p-dotierten Schicht und einer aktiven Schicht als Diffusionsbarriere einzufügen. In der Druckschrift JP 11068150 A wird ferner vorgeschlagen, eine Schicht mit Gitterstörungen zwischen der p-dotierten und der aktiven Schicht als Diffusionsbarriere für den p-Dotierstoff einzufügen.

Die Druckschrift US 2005/056824 A1 (BERGMANN MICHAEL JOHN [US] ET AL) 17. März 2005 (2005-03-17) offenbart einen strahlungsemittierenden optoelektronischen Halbleiterchip gemäß dem Oberbegriff des Anspruchs 1.

Der Erfindung liegt die Aufgabe zugrunde, einen strahlungsemittierenden optoelektronischen Halbleiterchip mit einer verbesserten Diffusionsbarriere zur effizienten Verminderung der Diffusion eines p-Dotierstoffs in die aktive Schicht anzugeben.

Diese Aufgabe wird durch einen strahlungsemittierenden optoelektronischen Halbleiterchip mit den Merkmalen des Patentanspruchs 1 gelöst. Vorteilhafte Ausgestaltungen und Weiterbildungen der Erfindung sind Gegenstand der abhängigen Ansprüche.

Bei einem erfindungsgemäßen strahlungsemittierenden optoelektronischen Halbleiterchip mit einer aktiven Schicht, mindestens einer p-dotierten Schicht und einer Schichtenfolge aus mehreren undotierten Schichten, die zwischen der aktiven Schicht und der p-dotierten Schicht angeordnet ist und mindestens eine erste undotierte Schicht und eine zweite undotierte Schicht enthält, wobei die zweite undotierte Schicht an die erste undotierte Schicht angrenzt und der ersten undotierten Schicht von der aktiven Schicht aus gesehen nachfolgt, enthalten die erste undotierte Schicht und die zweite undotierte Schicht Aluminium, wobei die erste undotierte Schicht einen Aluminiumanteil y1 und die zweite undotierte Schicht einen Aluminiumanteil y2 aufweist und der Aluminiumanteil y1 in der ersten undotierten Schicht größer ist als der Aluminiumanteil y2 in der zweiten undotierten Schicht.

Der Erfindung liegt insbesondere die Erkenntnis zugrunde, dass die Grenzfläche zwischen der zweiten undotierten Schicht und der ersten undotierten Schicht, die einen größeren Aluminiumanteil aufweist als die zweite undotierte Schicht, eine Diffusionsbarriere für einen p-Dotierstoff darstellt, der aus der p-dotierten Schicht in Richtung zur aktiven Schicht hin diffundiert. Auf diese Weise wird die Anreicherung eines p-Dotierstoffs, beispielsweise Mg oder Zn, in der aktiven Schicht des strahlungsemittierenden optoelektronischen Halbleiterchips effektiv vermindert. Dies hat insbesondere den Vorteil, dass Ladungsträgerrekombinationen durch nichtstrahlende Prozesse in der aktiven Schicht vermindert werden und somit die Effizienz der Lichterzeugung erhöht wird.

Bei einer ersten bevorzugten Ausführungsform der Erfindung weist die erste undotierte Schicht Inₓ₁Al_{y1}Ga_{1-x1-y1}P mit 0 ≤ x1 ≤ 1, 0 < y1 ≤ 1 und x1+y1 ≤ 1 und die zweite undotierte Schicht Inₓ₂Al_{y2}Ga_{1-x2-y2}P mit 0 ≤ x2 ≤ 1, 0 < y₂ < 1 und x2+y2 ≤ 1 auf.

Für den Aluminiumanteil y1 der ersten undotierten Schicht gilt bei der ersten Ausführungsform der Erfindung vorzugsweise y1 ≤ 0,2. Weiterhin weist die erste undotierte Schicht vorteilhaft nur einen geringen Galliumanteil auf, wobei für den Galliumanteil 1-x1-y1 der ersten undotierten Schicht vorteilhaft 1-x1-y1 ≤ 0,3 gilt. Besonders bevorzugt enthält die erste undotierte Schicht kein Gallium, das heißt es gilt 1-x1-y1 = 0. Beispielsweise kann die erste undotierte Schicht die Zusammensetzung In_{0,5}Al_{0,5}P aufweisen. In diesem Fall gilt also x1 = 0,5, y1 = 0,5 und 1-x1-y1 = 0.

Für den Aluminiumanteil y2 in der zweiten undotierten Schicht gilt bei der ersten Ausführungsform der Erfindung bevorzugt y2 ≤ 0,4. Weiterhin enthält die zweite undotierte Schicht bevorzugt Gallium, wobei für den Galliumanteil 1-x2-y2 vorzugsweise 1-x2-y2 ≥ 0,1 gilt. Beispielsweise kann die zweite undotierte Schicht die Zusammensetzung In_{0,5}Al_{0,25}Ga_{0,25}P aufweisen. In diesem Fall gilt also x2 = 0,5, y2 = 0,25 und 1-x2-y2 = 0,25.

Bei einer zweiten bevorzugten Ausführungsform der Erfindung weist die erste undotierte Schicht Inₓ₁Al_{y1}Ga_{1-x1-y1}N mit 0 ≤ x1 ≤ 1, 0 < y1 ≤ 1 und x1+y1 ≤ 1 und die zweite undotierte Schicht Inₓ₂Al_{y2}Ga_{1-x2-y2}N mit 0 ≤ x2 ≤ 1, 0 < y₂ < 1 und x2+y2 ≤ 1 auf.

Für den Aluminiumanteil y1 der ersten undotierten Schicht gilt bei der zweiten Ausführungsform der Erfindung vorzugsweise y1 ≥ 0,1. Weiterhin weist die erste undotierte Schicht bei dieser Ausführungsform vorteilhaft einen Galliumanteil auf, für den 1-x1-y1 ≤ 0,9 gilt. Insbesondere kann die erste undotierte Schicht kein Gallium enthalten, das heißt es gilt 1-x1-y1 = 0. Beispielsweise kann die erste undotierte Schicht die Zusammensetzung In_{0,5}Al_{0,5}N aufweisen. In diesem Fall gilt also x1 = 0,5, y1 = 0,5 und 1-x1-y1 = 0.

Für den Aluminiumanteil y2 in der zweiten undotierten Schicht gilt bei der zweiten Ausführungsform der Erfindung bevorzugt y2 < 0,3. Weiterhin enthält die zweite undotierte Schicht bevorzugt Gallium, wobei für den Galliumanteil 1-x2-y2 vorzugsweise 1-x2-y2 ≥ 0,7 gilt.

Bei beiden zuvor beschriebenen Ausführungsformen der Erfindung enthalten die erste undotierte Schicht und die zweite undotierte Schicht vorzugsweise Indium, so dass x1 > 0 und x2 > 0 gilt. Insbesondere können die erste undotierte Schicht und die zweite undotierte Schicht den gleichen Indiumanteil x1 = x2 aufweisen.

Weiterhin können auch die weiteren Halbleiterschichten des optoelektronischen Halbleiterchips, zum Beispiel die p-dotierte Schicht, jeweils aus einem Nitridverbindungshalbleiter, insbesondere InₓAl_{y}Ga_{1-x-y}N mit 0 ≤ x ≤ 1, 0 < y ≤ 1 und x+y ≤ 1, oder aus einem Phosphidverbindungshalbleiter, insbesondere InₓAl_{y}Ga_{1-x-y}P mit 0 ≤ x ≤ 1, 0 < y ≤ 1 und x+y ≤ 1, gebildet sein. Dabei muss das Halbleitermaterial nicht zwingend eine mathematisch exakte Zusammensetzung nach obigen Formeln aufweisen. Vielmehr kann es zusätzliche Bestandteile aufweisen, die die charakteristischen physikalischen Eigenschaften des Halbleitermaterials im wesentlichen nicht ändern. Der Einfachheit halber beinhalten obige Formeln jedoch nur die wesentlichen Bestandteile des Kristallgitters (A1, Ga, In, N oder P), auch wenn diese teilweise durch geringe Mengen weiterer Stoffe ersetzt sein können.

Die p-dotierte Schicht enthält vorzugsweise Mg oder Zn als Dotierstoff. Alternativ kann aber auch ein anderer p-Dotierstoff vorgesehen sein.

Es hat sich vorteilhaft herausgestellt, dass die Konzentration des p-Dotierstoffs aufgrund der als Diffusionsbarriere wirkenden Grenzfläche zwischen der zweiten undotierten Schicht und der ersten undotierten Schicht bereits in dem unmittelbar an die Grenzfläche angrenzenden Teilbereich der ersten undotierten Schicht signifikant abnimmt. Die mittlere Eindringtiefe des p-Dotierstoffs in die erste undotierte Schicht mit dem höheren Aluminiumanteil ist also vorteilhaft gering. Aus diesem Grund stellt bereits eine vergleichsweise dünne erste undotierte Schicht eine effektive Diffusionsbarriere für den p-Dotierstoff dar. Die Dicke der ersten undotierten Schicht beträgt vorzugsweise zwischen einschließlich 10 nm und einschließlich 1 µm, besonders bevorzugt zwischen einschließlich 20 nm und einschließlich 200 nm.

Gemäß der Erfindung beträgt die Gesamtdicke der zwischen der p-dotierten Schicht und der aktiven Schicht enthaltenen Schichtenfolge aus undotierten Schichten zwischen einschließlich 50 nm und einschließlich 1 µm.

Diese vergleichsweise geringe Gesamtdicke der undotierten Schichtenfolge wirkt sich vorteilhaft auf die optischen und elektronischen Eigenschaften des strahlungsemittierenden Halbleiterchips aus. Insbesondere werden durch die vergleichsweise geringe Dicke der zwischen der aktiven Schicht und der p-dotierten Schicht angeordneten undotierten Schichtenfolge Absorptionsverluste und Leckströme vermindert. Der zweiten undotierten Schicht folgt von der aktiven Schicht aus gesehen mindestens eine weitere undotierte Schicht nach, die einen geringeren Aluminiumanteil als die vorhergehende Schicht aufweist.

Insbesondere kann vorgesehen sein, dass jede der zwischen der aktiven Schicht und der p-dotierten Schicht angeordneten undotierten Schichten einen geringeren Aluminiumanteil als die ihr vorhergehende Schicht aufweist. Beispielsweise kann der zweiten undotierten Schicht eine dritte undotierte Schicht nachfolgen, die einen geringeren Aluminiumanteil als die zweite undotierte Schicht aufweist. Weiterhin kann zum Beispiel der dritten undotierten Schicht eine vierte undotierte Schicht nachfolgen, die einen geringeren Aluminiumanteil als die dritte undotierte Schicht aufweist. Ein p-Dotierstoff, der aus der p-dotierten Schicht in Richtung zur aktiven Schicht hin diffundiert, müsste bei dieser Ausführungsform der Erfindung mehrere Grenzflächen zwischen undotierten Schichten durchqueren, wobei an jeder der durchquerten Grenzflächen der Aluminiumanteil ansteigt. Die diffusionshemmende Wirkung wird dadurch im Vergleich zu einer einzelnen Grenzfläche, an der der Aluminiumanteil in Richtung von der p-dotierten Schicht zur aktiven Schicht hin ansteigt, vorteilhaft verstärkt, da in diesem Fall jede der Grenzflächen als Diffusionsbarriere wirkt.

In einer anderen Ausführungsform kann der zweiten undotierten Schicht von der aktiven Schicht aus gesehen auch eine Schichtenfolge mit abwechselnd höherem und geringerem Aluminiumgehalt folgen. Dann müsste ein p-Dotierstoff, der aus der p-dotierten Schicht in Richtung zur aktiven Schicht hin diffundiert, mehrere Grenzflächen zwischen undotierten Schichten durchqueren, wobei an jeder zweiten Grenzfläche der Aluminiumgehalt ansteigt. Im Gegensatz zur zuvor beschriebenen Ausführungsform sind damit an den jeweils zweiten Grenzflächen höhere Sprünge im Aluminiumgehalt realisierbar.

Die Erfindung ist insbesondere vorteilhaft für strahlungsemittierende Halbleiterchips, die eine epitaktische Schichtenfolge aufweisen, die bei einer vergleichsweise hohen Temperatur abgeschieden ist, da bei derartigen epitaktischen Schichtenfolgen die Gefahr besteht, dass der p-Dotierstoff aufgrund der hohen Temperaturen bereits beim Aufwachsen bis in die aktive Schicht diffundiert. Diese Gefahr besteht insbesondere bei epitaktischen Schichtenfolgen, die mittels MOVPE hergestellt werden.

Die Erfindung wird im Folgenden anhand von drei Ausführungsbeispielen in Zusammenhang mit den Figuren 1 bis 3 näher erläutert.

Es zeigen:
Figur 1 eine schematische Darstellung eines Querschnitts durch einen strahlungsemittierenden optoelektronischen Halbleiterchip gemäß einem Ausführungsbeispiel der Erfindung,
Figur 2 eine schematische Darstellung eines Querschnitts durch einen strahlungsemittierenden optoelektronischen Halbleiterchip gemäß einem weiteren Ausführungsbeispiel der Erfindung, und
Figur 3 eine schematische grafische Darstellung der Dotierstoffkonzentration D in logarithmischer Darstellung in Abhängigkeit von einer Ortskoordinate z bei einem weiteren Ausführungsbeispiel der Erfindung.

Gleiche oder gleich wirkende Elemente sind in den Figuren mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

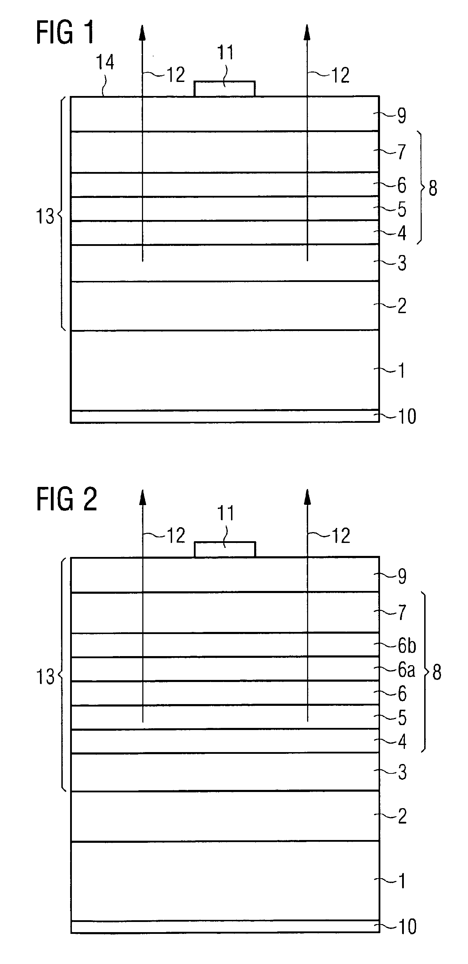

Der in Figur 1 schematisch im Querschnitt dargestellte strahlungsemittierende optoelektronische Halbleiterchip gemäß einem Ausführungsbeispiel der Erfindung enthält eine Halbleiterschichtenfolge 13, die auf ein Substrat 1 aufgebracht ist. Die Halbleiterschichtenfolge 13 ist vorzugsweise epitaktisch, insbesondere mittels metallorganischer Gasphasenepitaxie (MOVPE) auf das Substrat 1 aufgebracht. Bei dem strahlungsemittierenden Halbleiterchip kann es sich sowohl um einen Lumineszenzdiodenchip als auch um einen Laserdiodenchip handeln.

Der strahlungsemittierende Halbleiterchip enthält eine aktive Schicht 3, aus der elektromagnetische Strahlung 12, beispielsweise Strahlung 12 aus dem ultravioletten, sichtbaren oder infraroten Spektralbereich, emittiert wird. Die aktive Schicht 3 enthält bevorzugt Inₓ₃Al_{y3}Ga_{1-x3-y3}P oder Inₓ₃Al_{y3}Ga_{1-x3-y3}N mit 0 ≤ x3 ≤ 1, 0 ≤ y3 ≤ 1 und x3+y3 ≤ 1. Die aktive Schicht 3 kann zum Beispiel als Heterostruktur, Doppelheterostruktur oder als Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Zur Stromeinprägung in die aktive Schicht 3 sind beispielsweise zwei elektrische Kontakte 10, 11 vorgesehen, zum Beispiel ein erster elektrischer Kontakt 11 an einer Strahlungsaustrittsfläche 14 des Halbleiterchips und ein zweiter elektrischer Kontakt 10 an einer von der Halbleiterschichtenfolge 13 abgewandten Seite des Substrats 1.

Die Halbleiterschichtenfolge 13 enthält zumindest eine p-dotierte Schicht 9, die beispielsweise zwischen dem ersten elektrischen Kontakt 11 und der aktiven Schicht 3 angeordnet ist. Die p-dotierte Schicht 9 ist vorzugsweise mit Mg und/oder Zn dotiert.

Zwischen der aktiven Schicht 3 und der p-dotierten Schicht 9 ist eine Schichtenfolge 8 aus mehreren undotierten Schichten 4, 5, 6, 7 enthalten.

Die undotierte Schichtenfolge 8 enthält bei einer Ausführungsform der Erfindung eine erste undotierte Schicht 5 aus Inₓ₁Al_{y1}Ga_{1-x1-y1}P mit 0 ≤ x1 ≤ 1, 0 < y1 ≤ 1 und x1+y1 ≤ 1, und eine angrenzende zweite undotierte Schicht 6 aus Inₓ₂Al_{y2}Ga_{1-x2-y2}P mit 0 ≤ x2 ≤ 1, 0 < y2 ≤ 1 und x2+y2 ≤ 1. Der Aluminiumanteil y1 der ersten undotierten Schicht 5 beträgt bevorzugt y1 ≥ 0,2. Für den Aluminiumanteil y2 der zweiten undotierten Schicht 6 gilt bevorzugt y2 ≤ 0,4.

Bei einer anderen Ausführungsform enthält die undotierte Schichtenfolge 8 eine erste undotierte Schicht 5 aus Inₓ₁Al_{y1}Ga_{1-x1-y1}N mit 0 ≤ x1 ≤ 1, 0 < y1 ≤ 1 und x1+y1 ≤ 1, und eine angrenzende zweite undotierte Schicht 6 aus Inₓ₂Al_{y2}Ga_{1-x2-y2}N mit 0 ≤ x2 ≤ 1, 0 ≤ y2 ≤ 1 und x2+y2 ≤ 1. Der Aluminiumanteil y1 der ersten undotierten Schicht 5 beträgt in diesem Fall bevorzugt y1 ≥ 0,1 und für den Aluminiumanteil y2 der zweiten undotierten Schicht 6 gilt bevorzugt y2 < 0,3.

Bei beiden Ausführungsformen ist der Aluminiumanteil y1 der ersten undotierten Schicht 5 als der Aluminiumanteil y2 der zweiten undotierten Schicht 6, die der ersten undotierten Schicht 5 von der aktiven Schicht 3 aus gesehen nachfolgt.

In der Richtung von der p-dotierten Schicht 9 zur aktiven Schicht 3 hin nimmt der Aluminiumanteil also an der Grenzfläche von der zweiten undotierten Schicht 6 zur ersten undotierten Schicht 5 hin zu. Für einen p-Dotierstoff, der aus der p-dotierten Schicht 9 durch die undotierte Schicht 7 und die zweite undotierte Schicht 6 in Richtung zur aktiven Schicht 3 hin diffundiert, stellt die Grenzfläche zwischen der zweiten undotierten Schicht 6 und der ersten undotierten Schicht 5 eine Diffusionsbarriere dar. Dies bedeutet, dass der p-Dotierstoff vorteilhaft nur geringfügig in die erste undotierte Schicht 5 eindringen und diese insbesondere nicht oder zumindest nur zu einem geringfügigen Anteil durchqueren kann. Auf diese Weise wird eine Diffusion des p-Dotierstoffs in die aktive Schicht 3 effektiv vermindert.

Die Wirkung der ersten undotierten Schicht 5 kann vorteilhaft dadurch weiter verbessert werden, dass der Galliumanteil 1-x1-y1 in der ersten undotierten Schicht 5 geringer ist als der Galliumanteil 1-x2-y2 in der zweiten undotierten Schicht 6. Für den Galliumanteil gilt im Fall einer ersten undotierten Schicht 5 aus Inₓ₁Al_{y1}Ga_{1-x1-y1}P bevorzugt 1-x1-y1 ≤ 0,3 und im Fall einer ersten undotierten Schicht 5 aus Inₓ₁Al_{y1}Ga_{1-x1-y1}N vorzugsweise 1-x1-y1 ≤ 0,9. Besonders bevorzugt ist die erste undotierte Schicht 5 sogar frei von Gallium, so dass 1-x1-y1 = 0 gilt.

Die zweite undotierte Schicht 6 weist vorteilhaft einen größeren Galliumanteil als die erste undotierte Schicht 5 auf. Für den Galliumanteil 1-x2-y2 gilt im Fall einer zweiten undotierten Schicht 6 aus Inₓ₂Al_{y2}Ga_{1-x2-y2}P vorzugsweise 1-x2-y2 ≥ 0,1 und im Fall einer zweiten undotierten Schicht 6 aus Inₓ₂Al_{y2}Ga_{1-x2-y2}N bevorzugt 1-x2-y2 ≥ 0,7.

Zusätzlich zu der ersten undotierten Schicht 5 und der zweiten undotierten Schicht 6 kann die Schichtenfolge 8 weitere undotierte Schichten, beispielsweise eine zwischen der aktiven Schicht 3 und der ersten undotierten Schicht 5 angeordnete undotierte Schicht 4 enthalten. Eine weitere, zwischen der zweiten undotierten Schicht 6 und der p-dotierten Schicht 9 angeordnete undotierte Schicht 7 grenzt an die p-dotierte Schicht 9 an.

Die Wirkung der ersten undotierten Schicht 5 als Diffusionsbarriere tritt bereits bei einer vergleichsweise geringen Dicke ein. Vorzugsweise beträgt die Dicke der ersten undotierten Schicht 5 zwischen einschließlich 10 nm und einschließlich 1000 nm.

Insbesondere kann auch die Gesamtdicke der zwischen der aktiven Schicht 3 und der p-dotierten Schicht 9 angeordneten Schichtenfolge 8 aus undotierten Schichten 4, 5, 6, 7 aufgrund der Wirkung der ersten undotierten Schicht 5 als Diffusionsbarriere vergleichsweise gering sein. Die Gesamtdicke der Schichtenfolge 8 beträgt bevorzugt zwischen einschließlich 50 nm und einschließlich 1 µm. Die vergleichsweise geringe Gesamtdicke der undotierten Schichtenfolge 8 wirkt sich positiv auf die Effizienz des optoelektronischen Halbleiterchips aus, da auf diese Weise Leckströme und Absorptionsverluste verringert werden.

Weiterhin enthält die Halbleiterschichtenfolge 13 vorzugsweise zumindest eine n-leitende Schicht 2, die beispielsweise zwischen dem Substrat 1 und der aktiven Schicht 3 angeordnet ist. Anstelle der in Figur 1 dargestellten n-leitenden Schicht 2 zwischen dem Substrat 1 und der aktiven Schicht 3 kann auch eine Schichtenfolge aus mehreren Schichten, die beispielsweise auch undotierte Schichten enthalten kann, zwischen dem Substrat und der aktiven Schicht 3 vorgesehen sein.

Das in Figur 2 schematisch im Querschnitt dargestellte zweite Ausführungsbeispiel eines strahlungsemittierenden optoelektronischen Halbleiterchips gemäß der Erfindung unterscheidet sich von dem ersten Ausführungsbeispiel dadurch, dass der zweiten undotierten Schicht 6 von der aktiven Schicht aus gesehen zwei weitere undotierte Schichten 6a, 6b nachfolgen, die jeweils einen geringeren Aluminiumanteil aufweisen als die vorhergehende Schicht. Die der zweiten undotierten Schicht 6 nachfolgende undotierte Schicht 6a weist also einen geringeren Aluminiumanteil auf als die ihr vorhergehende zweite undotierte Schicht 6. Die weitere undotierte Schicht 6b, die der undotierten Schicht 6a nachfolgt, weist einen geringeren Aluminiumanteil auf als die ihr vorhergehende undotierte Schicht 6a.

Bei dieser Ausführungsform der Erfindung sind zwischen der p-dotierten Schicht und der aktiven Schicht 3 mehrere Grenzflächen enthalten, an denen der Aluminiumanteil von der p-dotierten Schicht 9 aus gesehen ansteigt. Die diffusionshemmende Wirkung wird auf diese Weise vorteilhaft verstärkt. Beispielsweise wirken bei dem in Figur 2 dargestellten Ausführungsbeispiel die Grenzfläche zwischen den Schichten 6b und 6a, die Grenzfläche zwischen den Schichten 6a und 6 und die Grenzfläche zwischen den Schichten 6 und 5 jeweils als Diffusionsbarriere für einen p-Dotierstoff, der aus der p-dotierten Schicht 9 in Richtung zur aktiven Schicht 3 hin diffundiert.

Alternativ kann der zweiten undotierten Schicht 6 von der aktiven Schicht aus gesehen auch eine Schichtenfolge mit abwechselnd höherem und geringerem Aluminiumgehalt folgen. In diesem Fall weist zum Beispiel die der zweiten undotierten Schicht 6 nachfolgende undotierte Schicht 6a einen größeren Aluminiumanteil auf als die ihr vorhergehende zweite undotierte Schicht 6. Die weitere undotierte Schicht 6b, die der undotierten Schicht 6a nachfolgt, weist einen geringeren Aluminiumanteil als die ihr vorhergehende undotierte Schicht 6a auf. In diesem Fall müsste ein p-Dotierstoff, der aus der p-dotierten Schicht 9 in Richtung zur aktiven Schicht 3 hin diffundiert, zwei Grenzflächen zwischen undotierten Schichten durchqueren, an denen der Aluminiumgehalt ansteigt.

Ansonsten entspricht das zweite Ausführungsbeispiel dem zuvor beschriebenen ersten Ausführungsbeispiel. Insbesondere gelten die im Zusammenhang mit dem ersten Ausführungsbeispiel beschriebenen vorteilhaften Ausgestaltungen der Erfindung ebenfalls für das zweite Ausführungsbeispiel.

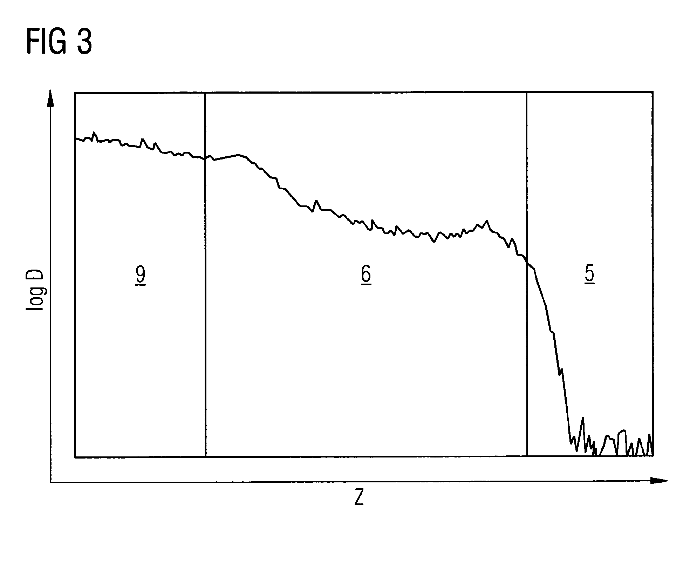

In Figur 3 ist die Konzentration D des Dotierstoffs Magnesium bei einem weiteren Ausführungsbeispiel der Erfindung in logarithmischer Darstellung in Abhängigkeit einer Ortskoordinate z aufgetragen, die von einer p-dotierten Schicht 9 in Richtung zu zwei undotierten Schichten 5, 6 hin verläuft. Die erste undotierte Schicht 5 ist bei diesem Ausführungsbeispiel eine Al_{0,5}In_{0,5}P-Schicht. An die erste undotierte Schicht 5 grenzt eine zweite undotierte Schicht 6 aus Al_{0,25}Ga_{0,25}In_{0,5}P an. An die zweite undotierte Schicht 6 grenzt eine mit Magnesium p-dotierte Schicht 9 aus Al_{0,5}In_{0,5}P an.

Während die Konzentration D des Dotierstoffs Magnesium als Folge von Diffusion in der zweiten undotierten Schicht 6 nur geringfügig geringer ist als in der p-dotierten Schicht 9, nimmt die Dotierstoffkonzentration in der ersten undotierten Schicht 5 mit zunehmendem Abstand von der Grenzfläche zur zweiten undotierten Schicht 6 deutlich ab. Die erste undotierte Schicht 5, die einen größeren Aluminiumanteil als die zweite undotierte Schicht 6 aufweist, wirkt also als Diffusionsbarriere für den Dotierstoff Magnesium.

Die Erfindung ist nicht durch die Beschreibung anhand der Ausführungsbeispiele beschränkt.

## Patentansprüche

1. Strahlungsemittierender optoelektronischer Halbleiterchip mit einer aktiven Schicht (3), die Inₓ₃Aly₃Ga_{1-x3-y3}P oder Inₓ₃Al_{y3}Ga_{1-x3-y3}N mit 0 ≤ x3 ≤ 1, 0 ≤ y3 ≤ 1 und x3 + y3 ≤ 1, aufweist, mindestens einer p-dotierten Schicht (9) und einer Schichtenfolge (8) aus mehreren undotierten Schichten (4, 5, 6, 7), die zwischen der aktiven Schicht (3) und der p-dotierten Schicht (9) angeordnet ist und mindestens eine erste undotierte Schicht (5) und eine zweite undotierte Schicht (6) enthält, wobei die zweite undotierte Schicht (6) an die erste undotierte Schicht (5) angrenzt und der ersten undotierten Schicht (5) von der aktiven Schicht (3) aus gesehen nachfolgt,
wobei die erste undotierte Schicht (5) und die zweite undotierte Schicht (6) Aluminium enthalten, wobei die erste undotierte Schicht (5) einen Aluminiumanteil y1 und die zweite undotierte Schicht (6) einen Aluminiumanteil y2 aufweist und der Aluminiumanteil y1 in der ersten undotierten Schicht (5) größer ist als der Aluminiumanteil y2 in der zweiten undotierten Schicht (6),
**dadurch gekennzeichnet, dass**
- der zweiten undotierten Schicht (6) von der aktiven Schicht (3) aus gesehen mindestens eine weitere undotierte Schicht (6a, 6b) nachfolgt, die einen geringeren Aluminiumanteil als die ihr vorhergehende Schicht aufweist, und
- die Gesamtdicke der zwischen der p-dotierten Schicht (9) und der aktiven Schicht (3) enthaltenen Schichtenfolge (8) aus undotierten Schichten (4, 5, 6, 7) zwischen einschließlich 50 nm und einschließlich 1 µm beträgt.

2. Strahlungsemittierender optoelektronischer Halbleiterchip nach Anspruch 1,
**dadurch gekennzeichnet, dass**
die erste undotierte Schicht (5) Inₓ₁Al_{y1}Ga_{1-x1-y1}P mit 0 ≤ x1 ≤ 1, 0 < y1 ≤ 1 und x1 + y1 ≤ 1 aufweist, und
die zweite undotierte Schicht (6) Inₓ₂Al_{y2}Ga_{1-x2-y2}P mit 0 ≤ x2 ≤ 1, 0 < y2 < 1 und x2 + y2 ≤ 1 aufweist.

3. Strahlungsemittierender optoelektronischer Halbleiterchip nach Anspruch 2,
**dadurch gekennzeichnet, dass**
für den Aluminiumanteil y1 der ersten undotierten Schicht (5) y1 ≥ 0,2 gilt.

4. Strahlungsemittierender optoelektronischer Halbleiterchip nach einem der Ansprüche 2 oder 3,
**dadurch gekennzeichnet, dass**
für den Galliumanteil 1-x1-y1 der ersten undotierten Schicht (5) 1-x1-y1 ≤ 0,3 gilt.

5. Strahlungsemittierender optoelektronischer Halbleiterchip nach Anspruch 4,
**dadurch gekennzeichnet, dass**
die erste undotierte Schicht (5) kein Gallium enthält.

6. Strahlungsemittierender optoelektronischer Halbleiterchip nach einem der Ansprüche 2 bis 5,
**dadurch gekennzeichnet, dass**
für den Aluminiumanteil y2 der zweiten undotierten Schicht (6) y2 ≤ 0,4 gilt.

7. Strahlungsemittierender optoelektronischer Halbleiterchip nach einem der Ansprüche 2 bis 6,
**dadurch gekennzeichnet, dass**
für den Galliumanteil 1-x2-y2 der zweiten undotierten Schicht (6) 1-x2-y2 ≥ 0,1 gilt.

8. Strahlungsemittierender optoelektronischer Halbleiterchip nach Anspruch 1,
**dadurch gekennzeichnet, dass**
die erste undotierte Schicht (5) InₓAl_{y1}Ga_{1-x1-y1}N mit 0 ≤ x1 ≤ 1, 0 < y1 ≤ 1 und x1 + y1 ≤ 1 aufweist, und
die zweite undotierte Schicht (6) Inₓ₂Al_{y2}Ga_{1-x2-y2}N mit 0 ≤ x2 ≤ 1, 0 < y2 < 1 und x2 + y2 ≤ 1 aufweist.

9. Strahlungsemittierender optoelektronischer Halbleiterchip nach Anspruch 8,
**dadurch gekennzeichnet, dass**
für den Aluminiumanteil y1 der ersten undotierten Schicht (5) y1 ≥ 0,1 gilt.

10. Strahlungsemittierender optoelektronischer Halbleiterchip nach einem der Ansprüche 8 oder 9,
**dadurch gekennzeichnet, dass**
für den Galliumanteil 1-x1-y1 der ersten undotierten Schicht (5) 1-x1-y1 ≤ 0,9 gilt.

11. Strahlungsemittierender optoelektronischer Halbleiterchip nach Anspruch 10,
**dadurch gekennzeichnet, dass**
die erste undotierte Schicht (5) kein Gallium enthält.

12. Strahlungsemittierender optoelektronischer Halbleiterchip nach einem der Ansprüche 8 bis 11,
**dadurch gekennzeichnet, dass**
für den Aluminiumanteil y2 der zweiten undotierten Schicht (6) y2 < 0,3 gilt.

13. Strahlungsemittierender optoelektronischer Halbleiterchip nach einem der Ansprüche 8 bis 12,
**dadurch gekennzeichnet, dass**
für den Galliumanteil 1-x2-y2 der zweiten undotierten Schicht (6) 1-x2-y2 ≥ 0,7 gilt.

14. Strahlungsemittierender optoelektronischer Halbleiterchip nach einem der Ansprüche 2 bis 13,
**dadurch gekennzeichnet, dass**
die erste undotierte Schicht (5) einen Indiumanteil x1 > 0 und die zweite undotierte Schicht (6) einen Indiumanteil x2 > 0 aufweist, wobei vorzugsweise x1 = x2 ist.

15. Strahlungsemittierender optoelektronischer Halbleiterchip nach einem der vorhergehenden Ansprüche,
**dadurch gekennzeichnet, dass**
die p-dotierte Schicht (9) Mg oder Zn als Dotierstoff enthält.

16. Strahlungsemittierender optoelektronischer Halbleiterchip nach einem der vorhergehenden Ansprüche,
**dadurch gekennzeichnet, dass**
die erste undotierte Schicht (5) eine Dicke von einschließlich 10 nm bis einschließlich 1000 nm aufweist.

## Claims

1. Radiation-emitting optoelectronic semiconductor chip comprising an active layer (3) which has Inₓ₃Aly₃Ga_{1-x3-y3}P or Inₓ₃Aly₃Ga_{1-x3-y3}N where 0 ≤ x3 ≤ 1, 0 ≤ y3 ≤ 1 and x3 + y3 ≤ 1, at least one p-doped layer (9) and a layer sequence (8) comprising a plurality of undoped layers (4, 5, 6, 7), which is arranged between the active layer (3) and the p-doped layer (9) and contains at least a first undoped layer (5) and a second undoped layer (6), the second undoped layer (6) adjoining the first undoped layer (5) and succeeding the first undoped layer (5) as seen from the active layer (3), the first undoped layer (5) and the second undoped layer (6) containing aluminum, the first undoped layer (5) having an aluminum proportion y1 and the second undoped layer (6) having an aluminum proportion y2 and the aluminum proportion y1 in the first undoped layer (5) being greater than the aluminum proportion y2 in the second undoped layer (6),
**characterized in that**
- the second undoped layer (6) is succeeded, as seen from the active layer (3), by at least one further undoped layer (6a, 6b) having a smaller aluminum proportion than the layer preceding it, and
- the total thickness of the layer sequence (8) comprising undoped layers (4, 5, 6, 7) which is contained between the p-doped layer (9) and the active layer (3) is between 50 nm and 1 µm inclusive.

2. Radiation-emitting optoelectronic semiconductor chip according to claim 1,
**characterized in that**
the first undoped layer (5) has Inₓ₁Al_{y1}Ga_{1-x1-y1}P where 0 ≤ x1 ≤ 1, 0 < y1 ≤ 1 and x1 + y1 ≤ 1, and the second undoped layer (6) has Inₓ₂Aly₂Ga_{1-x2-y2}P where 0 ≤ x2 ≤ 1, 0 < y2 ≤ 1 and x2 + y2 ≤ 1.

3. Radiation-emitting optoelectronic semiconductor chip according to claim 2,
**characterized in that**
for the aluminum proportion y1 of the first undoped layer (5), y1 ≥ 0.2 holds true.

4. Radiation-emitting optoelectronic semiconductor chip according to either of claims 2 and 3,
**characterized in that**
for the gallium proportion 1-x1-y1 of the first undoped layer (5), 1-x1-y1 ≤ 0.3 holds true.

5. Radiation-emitting optoelectronic semiconductor chip according to claim 4,
**characterized in that**
the first undoped layer (5) contains no gallium.

6. Radiation-emitting optoelectronic semiconductor chip according to one of claims 2 to 5,
**characterized in that**
for the aluminum proportion y2 of the second undoped layer (6), y2 ≤ 0.4 holds true.

7. Radiation-emitting optoelectronic semiconductor chip according to one of claims 2 to 6,
**characterized in that**
for the gallium proportion 1-x2-y2 of the second undoped layer (6) 1-x2-y2 ≥ 0.1 holds true.

8. Radiation-emitting optoelectronic semiconductor chip according to claim 1,
**characterized in that**
the first undoped layer (5) has Inₓ₁Al_{y1}Ga_{1-x1-y1}N where 0 ≤ x1 ≤ 1, 0 < y1 ≤ 1 and x1 + y1 ≤ 1, and the second undoped layer (6) has Inₓ₂Aly₂Ga_{1-x2-y2}N where 0 ≤ x2 ≤ 1, 0 < y2 < 1 and x2 + y2 ≤ 1.

9. Radiation-emitting optoelectronic semiconductor chip according to claim 8,
**characterized in that**
for the aluminum proportion y1 of the first undoped layer (5), y1 ≥ 0.1 holds true.

10. Radiation-emitting optoelectronic semiconductor chip according to either of claims 8 and 9,
**characterized in that**
for the gallium proportion 1-x1-y1 of the first undoped layer (5), 1-x1-y1 ≤ 0.9 holds true.

11. Radiation-emitting optoelectronic semiconductor chip according to claim 10,
**characterized in that**
the first undoped layer (5) contains no gallium.

12. Radiation-emitting optoelectronic semiconductor chip according to one of claims 8 to 11,
**characterized in that**
for the aluminum proportion y2 of the second undoped layer (6), y2 < 0.3 holds true.

13. Radiation-emitting optoelectronic semiconductor chip according to one of claims 8 to 12,
**characterized in that**
for the gallium proportion 1-x2-y2 of the second undoped layer (6) 1-x2-y2 ≥ 0.7 holds true.

14. Radiation-emitting optoelectronic semiconductor chip according to one of claims 2 to 13,
**characterized in that**
the first undoped layer (5) has an indium proportion x1 > 0 and the second undoped layer (6) has an indium proportion x2 > 0, it preferably being the case that x1 = x2.

15. Radiation-emitting optoelectronic semiconductor chip according to one of the preceding claims,
**characterized in that**
the p-doped layer (9) contains Mg or Zn as dopant.

16. Radiation-emitting optoelectronic semiconductor chip according to one of the preceding claims,
**characterized in that**
the first undoped layer (5) has a thickness of from 10 nm to 1000 nm inclusive.

## Revendications

1. Puce optoélectronique semi-conductrice émettant un rayonnement, dotée d'une couche active (3) qui présente de l'Inₓ₃Aly₃Ga_{1-x3-y3}P ou de l'InₓₐAly₃Ga₁₋ₓ₃₋y₃N, avec 0 ≤ x3 ≤1, 0 ≤ y3 ≤1 et x3 + y3 ≤1, d'au moins une couche (9) à dopage p et une succession (8) constituée de plusieurs couches (4, 5, 6, 7) non dopées, disposée entre la couche active (3) et la couche (9) à dopage p, et d'au moins une première couche (5) non dopée et une deuxième couche (6) non dopée,
la deuxième couche (6) non dopée étant adjacente à la première couche (5) non dopée et suivant la première couche (5) non dopée partant de la couche active (3),
la première couche (5) non dopée et la deuxième couche (6) non dopée contenant de l'aluminium,
la première couche (5) non dopée présentant une teneur y1 en aluminium et la deuxième couche (6) non dopée une teneur y2 en aluminium, la teneur y1 en aluminium de la première couche (5) non dopée étant supérieure à la teneur y2 en aluminium de la deuxième couche (6) non dopée,
**caractérisée en ce que**
partant de la couche active (3), une autre couche (6a, 6b) qui présente une teneur en aluminium plus basse que celle de la couche qui la précède suit la deuxième couche (6) non dopée et
**en ce que** l'épaisseur totale de la succession (8) de couches (4, 5, 6, 7) non dopées incluse entre la couche (9) à dopage p et la couche active (3) est comprise entre 50 nm et 1 µm, ces valeurs incluses.

2. Puce optoélectronique semi-conductrice émettant un rayonnement selon la revendication 1, **caractérisée en ce que** la première couche (5) non dopée présente de l'Inₓ₁Al_{y1}Ga_{1-x1-y1}P avec 0 ≤ x1 ≤1, 0 < y1 ≤ 1 et x1 + y1 ≤ 1 et la deuxième couche (6) non dopée présente de l' Inₓ₂Al_{y2}Ga_{1-x2-y2}P avec 0 ≤ x2 ≤ 1, 0 < y2 < 1 et x2 + y2 ≤ 1.

3. Puce optoélectronique semi-conductrice émettant un rayonnement selon la revendication 2, **caractérisée en ce que** pour la teneur y1 en aluminium de la première couche (5) non dopée, on a y1 ≥ 0,2.

4. Puce optoélectronique semi-conductrice émettant un rayonnement selon l'une des revendications 2 ou 3, **caractérisée en ce que** pour la teneur 1-x1-y1 en gallium de la première couche (5) non dopée, on a 1-x1-y1 ≤ 0,3.

5. Puce optoélectronique semi-conductrice émettant un rayonnement selon la revendication 4, **caractérisée en ce que** la première couche (5) non dopée ne contient pas de gallium.

6. Puce optoélectronique semi-conductrice émettant un rayonnement selon l'une des revendications 2 à 5, **caractérisée en ce que** pour la teneur y2 en aluminium de la deuxième couche (6) non dopée, on a y2 ≤ 0,4.

7. Puce optoélectronique semi-conductrice émettant un rayonnement selon l'une des revendications 2 à 6, **caractérisée en ce que** pour la teneur 1-x2-y2 en gallium de la deuxième couche (6) non dopée, on a 1-x2-y2 ≥ 0,1.

8. Puce optoélectronique semi-conductrice émettant un rayonnement selon la revendication 1, **caractérisée en ce que** la première couche (5) non dopée présente de l'Inₓ₁Al_{y1}Ga_{1-x1-y1}N avec 0 ≤ x1 ≤ 1, 0 < y1 ≤ 1 et x1 + y1 ≤ 1 et **en ce que** la deuxième couche (6) non dopée contient de l'Inₓ₂Aly₂Ga_{1-x2-y2}N avec 0 ≤ x2 ≤ 1, 0 < y2 < 1 et x2 + y2 ≤ 1.

9. Puce optoélectronique semi-conductrice émettant un rayonnement selon la revendication 8, **caractérisée en ce que** pour la teneur y1 en aluminium de la première couche (5) non dopée, on a y1 ≥ 0,1.

10. Puce optoélectronique semi-conductrice émettant un rayonnement selon l'une des revendications 8 ou 9, **caractérisée en ce que** pour la teneur 1-x1-y1 en gallium de la première couche (5) non dopée, on a 1-x1-y1 ≤ 0,9.

11. Puce optoélectronique semi-conductrice émettant un rayonnement selon la revendication 10, **caractérisée en ce que** la première couche (5) non dopée ne contient pas de gallium.

12. Puce optoélectronique semi-conductrice émettant un rayonnement selon l'une des revendications 8 à 11, **caractérisée en ce que** pour la teneur y2 en aluminium de la deuxième couche (6) non dopée, on a y2 < 0,3.

13. Puce optoélectronique semi-conductrice émettant un rayonnement selon l'une des revendications 8 à 12, **caractérisée en ce que** pour la teneur 1-x2-y2 en gallium de la deuxième couche (6) non dopée, on a 1-x2-y2 ≥ 0,7.

14. Puce optoélectronique semi-conductrice émettant un rayonnement selon l'une des revendications 2 à 13, **caractérisée en ce que** la première couche (5) non dopée présente une teneur x1 en indium > 0 et la deuxième couche (6) non dopée une teneur x2 en indium > 0, avec de préférence x1 = x2.

15. Puce optoélectronique semi-conductrice émettant un rayonnement selon l'une des revendications précédentes, **caractérisée en ce que** la couche (9) à dopage p contient du Mg ou du Zn comme substance de dopage.

16. Puce optoélectronique semi-conductrice émettant un rayonnement selon l'une des revendications précédentes, **caractérisée en ce que** la première couche (5) non dopée présente une épaisseur comprise entre 10 nm et 1 000 nm, ces valeurs incluses.
